# EUROPEAN PATENT APPLICATION

(11) **EP 2 735 834 A1**
(43) Date of publication of application: **28.05.2014**
(21) Application number: 12814288.2
(22) Date of filing: 17.07.2012
(51) Int. Cl.: F28D 15/02, H01L 23/427

(54) **COOLING APPARATUS, ELECTRONIC APPARATUS PROVIDED WITH SAME, AND ELECTRIC VEHICLE**

(30) Priority: 21.07.2011 JP 2011159664; 22.06.2012 JP 2012140507
(71) Applicant: Panasonic Corporation, Osaka 571-8501 (JP)
(72) Inventor: SATO, Kaoru, Chuo-ku, Osaka 540-6207 (JP); SUGIYAMA, Makoto, Chuo-ku, Osaka 540-6207 (JP); MIYAKE, Shunji, Chuo-ku, Osaka 540-6207 (JP); MIYAMOTO, Hiroyuki, Chuo-ku, Osaka 540-6207 (JP); NOGAMI, Wakana, Chuo-ku, Osaka 540-6207 (JP); SUZUKI, Ayaka, Chuo-ku, Osaka 540-6207 (JP)
(74) Representative: Grünecker, Kinkeldey, Stockmair & Schwanhäusser
(86) International application number: PCT/JP2012/004558
(87) International publication number: WO 2013/011682

(57) **Abstract**

A cooling apparatus includes: a heat receiving portion including a heat receiving plate which transfers heat from a heat source to a working fluid; a heat radiating portion which discharges the heat of the working fluid; and a heat radiating path and a return path which connect the heat receiving portion and the heat radiating portion to each other. In the cooling apparatus, the working fluid is circulated through the heat receiving portion, the heat radiating path, the heat radiating portion, the return path and the heat receiving portion to dissipate the heat of the heat source. A check valve which controls a flow of the working fluid is provided in the return path at a location near the heat receiving portion or provided in the heat receiving portion. The check valve includes a valve seat including a valve hole, a case including a recess, and a valve plate which is sandwiched between the valve seat and the case, which opens and closes the valve hole, and which includes a valve-movable portion that moves in the recess.

## Description

### TECHNICAL FIELD

The present invention relates to a cooling apparatus, an electronic apparatus provided with same, and an electric vehicle.

### BACKGROUND ART

A cooling apparatus mounted in a power converter circuit of an electric vehicle is known. In the electric vehicle, an electric motor which is a driving power source is switched and driven by an inverter circuit which is a power converter circuit. In the inverter circuit, a plurality of semiconductor switching elements such as power transistors are used, and high current as high as tens of amperes flows through the semiconductor switching elements. Hence, the semiconductor switching elements are highly heated and it is necessary to cool the semiconductor switching elements.

For this reason, as disclosed in PTL 1, in an ebullient cooling apparatus provided with a refrigerant radiator at its upper part and a refrigerant tank at its lower part, an inverter circuit disposed on a lower part of the ebullient cooling apparatus is cooled. In such a conventional cooling apparatus, the refrigerant tank is disposed such that it is in contact with the semiconductor switching elements. A liquefied refrigerant in the refrigerant tank draws heat of the switching elements and evaporates. The evaporated refrigerant rises to the refrigerant radiator disposed in the upper part of the ebullient cooling apparatus; the evaporated refrigerant is cooled and liquefied. The liquefied refrigerant again drops to the lower part of the ebullient cooling apparatus. This cycle is repeated. That is, a refrigerant is circulated by natural convection.

However, in such a natural convection type cooling apparatus, the heat of the switching element is transferred to a liquefied refrigerant collected in the refrigerant tank through a wall surface (heat transfer surface) of the refrigerant tank. That is, the heat of the switching element is only transferred by gentle convection heat transfer. Therefore, the heat transfer efficiency in the heat transfer surface cannot be enhanced, and the switching element is not efficiently cooled.

### Citation List

### Patent Literature

PTL 1: Unexamined Japanese Patent Publication No. H8-126125

### SUMMARY OF THE INVENTION

A cooling apparatus of the present invention includes: a heat receiving portion including a heat receiving plate which transfers heat from a heat source to a working fluid; a heat radiating portion which discharges the heat of the working fluid; and a heat radiating path and a return path which connect the heat receiving portion and the heat radiating portion to each other. In the cooling apparatus, the working fluid is circulated through the heat receiving portion, the heat radiating path, the heat radiating portion, the return path and the heat receiving portion to dissipate the heat of the heat source. A check valve which controls a flow of the working fluid is provided in the return path at a location near the heat receiving portion or provided in the heat receiving portion. The check valve includes a valve seat including a valve hole, a case including a recess, and a valve plate which is sandwiched between the valve seat and the case, which opens and closes the valve hole, and which includes a valve-movable portion that moves in the recess.

According to the cooling apparatus of such a configuration, the valve plate is opened by a pressure balance between a head pressure of the working fluid collected above the valve plate and internal pressure in the heat receiving portion, and the valve-movable portion moves in the recess of the case. Therefore, the check valve does not excessively open. Hence, the working fluid is not excessively supplied into the heat receiving portion, and an appropriate amount of working fluid is supplied. A volume of a portion of the working fluid which drops to the heat receiving plate is expanded by initial boiling, and the remaining working fluid which is not yet boiled spreads over an entire surface of the heat receiving plate as a thin film. The thin film working fluid receives the heat of the heated heat receiving plate, and the working fluid is heated and evaporated in an instant. As a result, heat transfer efficiency on the heat transfer surface is enhanced and a cooling effect is enhanced.

Further, by the volume expansion caused by evaporation, the working fluid moves energetically on the heat receiving plate and therefore, the heat transfer efficiency on the heat transfer surface is enhanced and a cooling effect is enhanced.

### BRIEF DESCRIPTION OF DRAWINGS

FIG. 1 is a schematic diagram of an electric vehicle of a first embodiment of the present invention.
FIG. 2 is a schematic diagram of a cooling apparatus.
FIG. 3 is an exploded perspective view of a check valve of the cooling apparatus.
FIG. 4 is a partially cut-away perspective view of the check valve of the cooling apparatus.
FIG. 5A is a sectional view of vicinity of the check valve of the cooling apparatus.
FIG. 5B is a sectional view taken along line 5B-5B in FIG. 5A.
FIG. 6A is a sectional view of a state where a valve-movable portion of the check valve of the cooling apparatus closes a valve hole in the first embodiment of the present invention.
FIG. 6B is a sectional view taken along line 6B-6B in FIG. 6A.
FIG. 7 is a schematic diagram of a cooling apparatus of a second embodiment of the present invention.
FIG. 8A is an exploded perspective view of a check valve of the cooling apparatus.
FIG. 8B is a perspective view of an assembled state of the check valve of the cooling apparatus.
FIG. 8C is a sectional view taken along line 8C-8C in FIG. 8B.
FIG. 9A is a schematic diagram of a configuration of a check valve-mounting portion of the cooling apparatus of the second embodiment of the present invention.
FIG. 9B is an enlarged diagram of the configuration of the check valve-mounting portion of the cooling apparatus.
FIG. 10 is a schematic perspective view of an electronic apparatus provided with the cooling apparatus.

### DESCRIPTION OF EMBODIMENTS

Embodiments of the present invention will be described below with reference to the drawings.

### FIRST EXEMPLARY EMBODIMENT

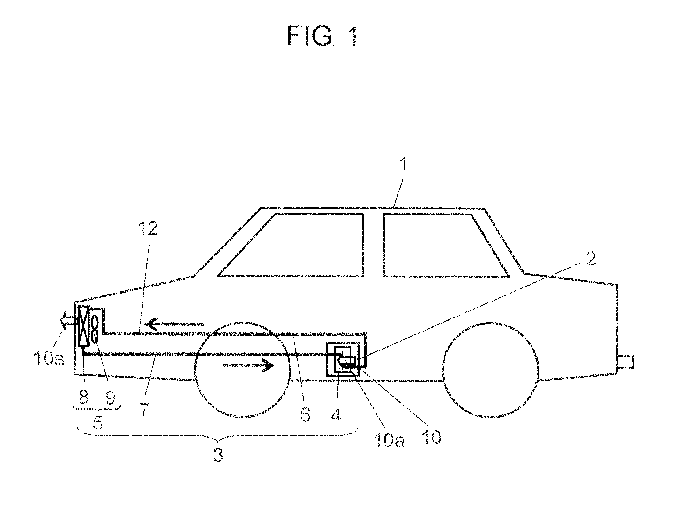

FIG. 1 is a schematic diagram of an electric vehicle of a first embodiment of the present invention. As shown in FIG. 1, an electric motor (not shown) which drives an axle (not shown) of electric vehicle 1 is connected to inverter circuit 2 which is a power converter disposed in electric vehicle 1. Inverter circuit 2 includes plurality of semiconductor switching elements 10 which supply electricity to the electric motor, and inverter circuit 2 generates heat when semiconductor switching elements 10 are operated.

Cooling apparatus 3 cools semiconductor switching elements 10. Cooling apparatus 3 includes heat receiving portion 4, heat radiating portion 5, heat radiating path 6, and return path 7. Here, heat radiating portion 5 releases heat 10a which is absorbed by working fluid 12 (e.g., water) in heat receiving portion 4. Heat radiating path 6 and return path 7 are circulation paths of working fluid 12, which connect heat receiving portion 4 and heat radiating portion 5 to each other. In the circulation path, working fluid 12 is gas (water vapor in the case of water), liquid and a mixture thereof. Working fluid 12 circulates in one direction through heat receiving portion 4, heat radiating path 6, heat radiating portion 5, return path 7, and heat receiving portion 4.

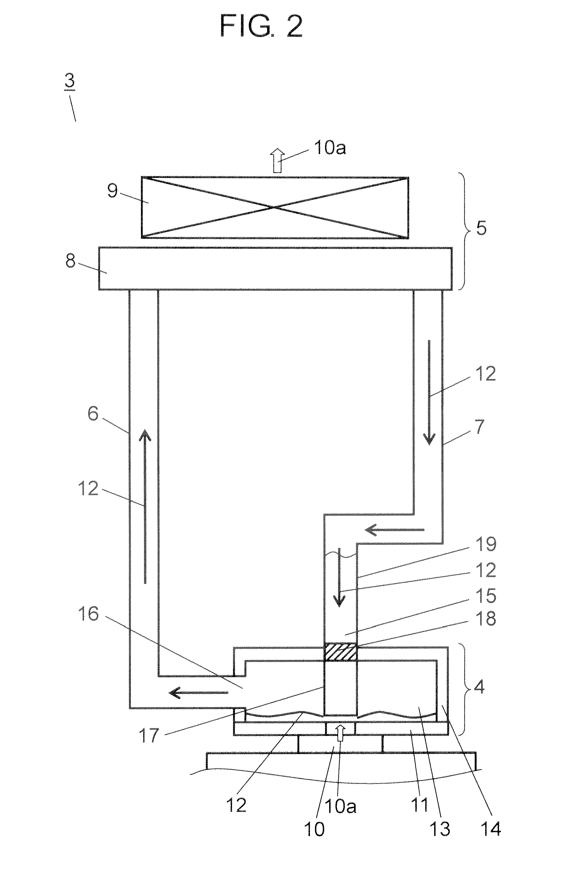

FIG. 2 is a schematic diagram of the cooling apparatus of the first embodiment of the present invention. As shown in FIG. 2, heat radiating portion 5 includes heat radiating body 8 which releases heat to outside air. Heat radiating body 8 is composed of a block body (not shown) which is formed by thinly forming aluminum into strip fins and by laminating the strip fins on one another at predetermined distances. Blower 9 blows outside air onto a surface of heat radiating body 8 and the surface of heat radiating body 8 radiates the heat. Heat radiation from the surface of heat radiating body 8 may be utilized for heating a vehicle interior of electric vehicle 1.

As shown in FIG. 2, heat receiving portion 4 includes heat receiving plate 11 which absorbs heat 10a by coming into contact with semiconductor switching elements 10 serving as a heat source, and which transfers heat 10a to working fluid 12. Heat receiving portion 4 also includes heat receiving plate cover 14 which covers a surface of heat receiving plate 11 and which forms heat receiving space 13 for evaporation of working fluid 12 which flows into heat receiving space 13.

Heat receiving plate cover 14 is provided with inflow port 15 through which liquefied working fluid 12 flows into heat receiving space 13, and discharge port 16 through which evaporated working fluid 12 is discharged from heat receiving space 13.

That is, inflow port 15 is formed in an upper surface of heat receiving plate cover 14, and discharge port 16 is formed in a side surface of heat receiving plate cover 14. Return path 7 is connected to inflow port 15, and heat radiating path 6 is connected to discharge port 16.

Inflow pipe 19 through which working fluid 12 is supplied into heat receiving portion 4 is connected to return path 7 at one end next to heat receiving portion 4 in a state where inflow pipe 19 projects into heat receiving space 13. In the following description, a portion of inflow pipe 19 existing in heat receiving space 13 is described as introduction pipe 17.

In the first embodiment of the present invention, an inlet portion of introduction pipe 17 includes check valve 18. Check valve 18 is provided in return path 7 at a location in the vicinity of heat receiving portion 4 or provided in heat receiving portion 4, and check valve 18 controls a flow of working fluid 12.

An effect of cooling apparatus 3 configured as described above will be described.

In the above-described configuration, when semiconductor switching elements 10 of inverter circuit 2 shown in FIG. 1 start operating, electricity is supplied to the electric motor, and electric vehicle 1 starts moving. At this time, high current flows into semiconductor switching elements 10, at least several % of entire electricity is lost and semiconductor switching elements 10 generate the heat.

Meanwhile, the heat generated by semiconductor switching elements 10 shown in FIG. 2 is transferred to liquid working fluid 12 supplied onto heat receiving plate 11 of heat receiving space 13. That is, when heat 10a of semiconductor switching elements 10 is transferred to working fluid 12, liquid working fluid 12 evaporates in an instant, flows from discharge port 16 to heat radiating path 6, and releases heat 10a to outside air in heat radiating portion 5.

Working fluid 12 whose heat 10a is released from heat radiating portion 5 is liquefied, flows into return path 7, and is collected in inflow pipe 19 existing above check valve 18. Liquefied working fluid 12 gradually increases in return path 7. On the other hand, working fluid 12 in heat receiving space 13 is reduced by its evaporation and pressure in heat receiving space 13 is also reduced. Hence, check valve 18 is pushed down and is opened by a head pressure of working fluid 12 collected above check valve 18, and working fluid 12 is again supplied onto heat receiving plate 11 in heat receiving space 13. Working fluid 12 circulates in cooling apparatus 3 in this manner and semiconductor switching elements 10 are cooled.

Here, a cooling mechanism in heat receiving space 13 will be described.

In heat receiving space 13 shown in FIG. 2, working fluid 12 from return path 7 becomes liquid drop and drops from check valve 18 onto heat receiving plate 11. A surface of heat receiving plate 11 has such a shape that a flow path radially enlarges. An appropriate amount of working fluid 12 is supplied due to a later-described effect of check valve 18. Supplied working fluid 12 spreads on heat receiving plate 11 as a thin film. A back surface of heat receiving plate 11 is in contact with semiconductor switching elements 10. Hence, working fluid 12 which becomes the thin film is heated and evaporated in an instant.

Further, barometric pressure in the circulation path including heat receiving space 13 is set lower than atmospheric pressure. Hence, even if water is used as working fluid 12, working fluid 12 is evaporated at a temperature lower than a boiling temperature of water in atmospheric pressure.

In the first embodiment of the present invention, barometric pressure in the circulation path is -97 KPa and an interior of the circulation path is brought into a saturated vapor state. Hence, a boiling temperature suitable for an outside air temperature is determined, and water of working fluid 12 is easily evaporated. At this time, working fluid 12 takes heat 10a of semiconductor switching elements 10 and cools elements 10.

When working fluid 12 is evaporated, pressure in heat receiving space 13 increases. However, by the operation of check valve 18, it is possible to avoid a case where working fluid 12 reversely flows and returns toward return path 7, and working fluid 12 is reliably discharged from discharge port 16 toward heat radiating path 6. Since cooling apparatus 3 operates in this manner, a regular cycle of heat reception and heat radiation is realized. Working fluid 12 is continuously evaporated in heat receiving space 13, and semiconductor switching elements 10 is cooled.

Here, the most characteristic portions of the first embodiment of the present invention will be described.

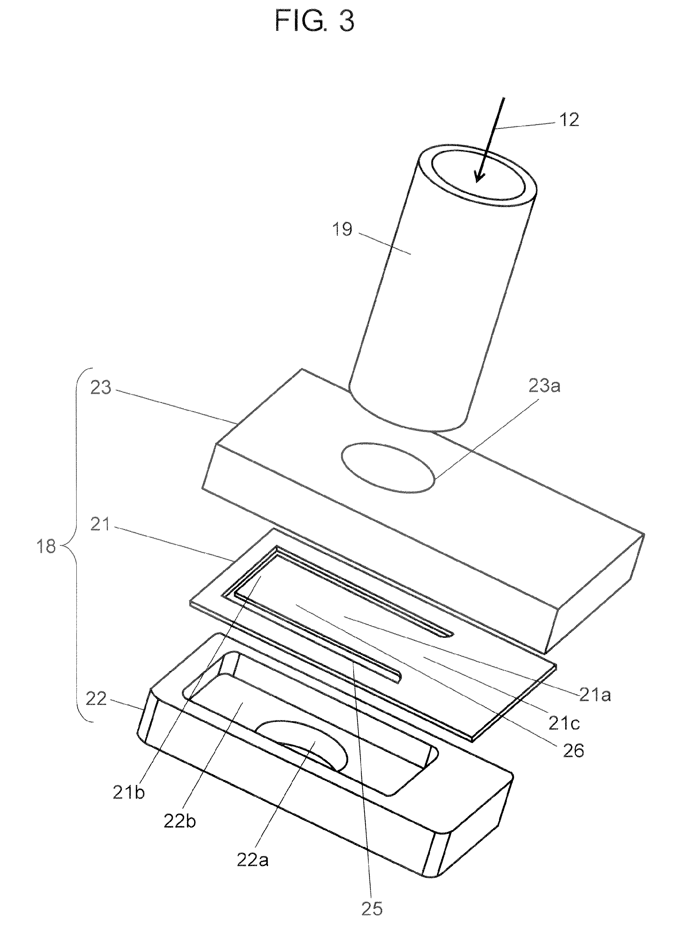

FIG. 3 is an exploded perspective view of the check valve of the cooling apparatus of the first embodiment of the present invention. As shown in FIG. 3, check valve 18 is composed of valve plate 21 which controls a flow of working fluid 12, case 22 which holds valve plate 21, and valve seat 23. Case 22 includes recess 22b. Valve plate 21 includes valve-movable portion 21a which moves in recess 22b. Case 22 and valve seat 23 are respectively provided with case hole 22a and valve hole 23a having the same diameters as an inner diameter of inflow pipe 19. A material of valve plate 21 is copper, brass or SUS (Steel Use Stainless). A thickness of valve plate 21 is 100 µm to 200 µm.

U-shaped cut-groove 25 is provided on the inner side of valve plate 21, and valve-movable portion 21a is formed on the inner side of cut-groove 25. That is, valve-movable portion 21a is region 26 surrounded by U-shaped cut-groove 25. Valve-movable portion 21a includes free end 21b whose displacement from valve plate 21 is the largest and fixed end 21c whose displacement from valve plate 21 is zero.

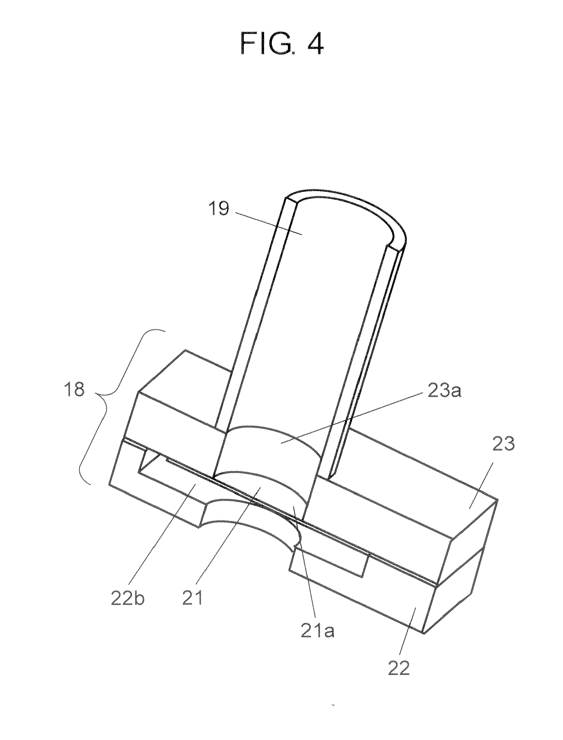

FIG. 4 is a partially cut-away perspective view of the check valve of the cooling apparatus of the first embodiment of the present invention. As shown in FIG. 4, valve plate 21 is sandwiched between case 22 and valve seat 23 and fixed thereto so that valve-movable portion 21a falls within recess 22b of case 22. Case 22 and valve seat 23 are fixed through screws (not shown). Valve-movable portion 21a is sandwiched between valve seat 23 and case 22 and opens and closes valve hole 23a.

Valve-movable portion 21a moves only in recess 22b of case 22. A depth of recess 22b is about 1 mm to 2 mm, and a gap between valve-movable portion 21a and an inner wall of recess 22b is also about 1 mm to 2 mm. According to this configuration, even if check valve 18 shown in FIG. 2 opens, working fluid 12 is not excessively supplied into heat receiving portion 4, and a supply amount of working fluid 12 is controlled appropriately.

Working fluid 12 which drops onto heat receiving plate 11 spreads as a thin film such that working fluid 12 is dispersed in the peripheries of a surface of heat receiving plate 11 as described above. Working fluid 12 is heated by heat 10a of heat receiving plate 11, and is evaporated in an instant. Hence, heat transfer efficiency in the heat transfer surface is enhanced, and efficient cooling operation is carried out. Since the volume is expanded by evaporation, working fluid 12 in heat receiving plate 11 moves to the discharge port 16 with great force, and therefore, the heat transfer efficiency in the heat transfer surface is further enhanced.

In the first embodiment of the present invention, valve plate 21 of check valve 18 is disposed substantially horizontally. However, if valve plate 21 can move by the head pressure of working fluid 12, a direction in which valve plate 21 is disposed may be inclined with respect to the horizontal direction or may be substantially vertical. However, if response obtained by a relation between an amount of working fluid 12 and pressure caused by the head is taken into consideration, it is preferable that the direction in which valve plate 21 is disposed is substantially horizontal.

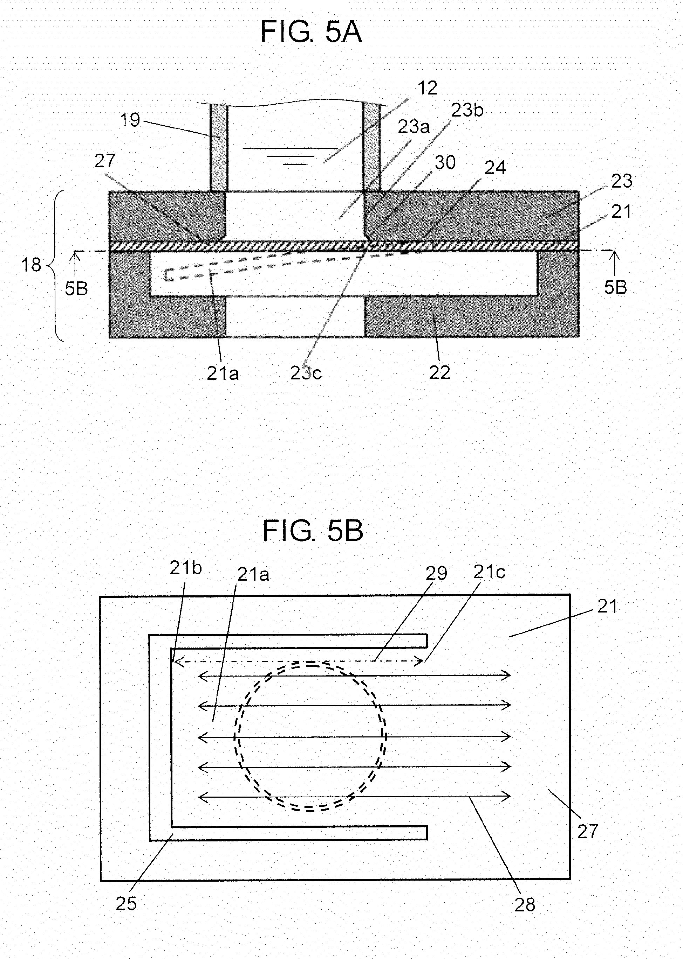

FIG. 5A is a sectional view of vicinity of the check valve of the cooling apparatus of the first embodiment of the present invention, and FIG. 5B is a sectional view taken along line 5B-5B in FIG. 5A. As shown in FIG. 5A, valve seat 23 includes flat abutment surface 24 which is in close contact with valve plate 21. Hence, air tightness between valve seat 23 and valve plate 21 is enhanced, a reverse-flow preventing effect of working fluid 12 from heat receiving portion 4 is enhanced. When valve-movable portion 21a opens and closes, collision between valve-movable portion 21a and a wide area of flat abutment surface 24 is repeated. Hence, as compared with a case where there is no flat abutment surface 24 and direct collision against a narrow area of an end surface of inflow pipe 19 is repeated, damage of valve plate 21 is small and durability of valve plate 21 is enhanced.

Valve hole-forming surface 23b forming valve hole 23a is in contact with valve plate 21 at valve hole valve plate contact portion 23c. Valve hole valve plate contact portion 23c is provided with chamfered portion 30. When a projection exists on valve hole valve plate contact portion 23c which is an open edge of valve hole 23a, valve-movable portion 21a is easily damaged when it opens or closes if the projection vertically abuts against valve plate 21. Hence, when chamfered portion 30 which moderates impact caused at the time of abutment is provided, even if valve plate 21 and valve hole valve plate contact portion 23c abut against each other, the impact is moderated and the open edge of valve hole 23a is not damaged. Therefore, durability of valve plate 21 is further enhanced.

Valve plate 21 is formed by metal plate 27. As shown in FIG. 5B, rolling direction 28 of metal plate 27 is the same as valve-movable portion direction 29 from fixed end 21c toward free end 21b. Hence, even if valve-movable portion 21a is vertically bent repeatedly when it opens or closes, metal fatigue is less prone to be generated.

Cut-groove 25 and an outer peripheral portion of valve plate 21 formed by metal plate 27 shown in FIG. 5B are cut, by stamping or the like, in a direction from one side facing valve seat 23 to another side facing case 22 shown in FIG. 5A. Hence, a burr generated at the time of the cutting operation is directed toward case 22, and valve seat 23 is not damaged when valve-movable portion 21a opens and closes.

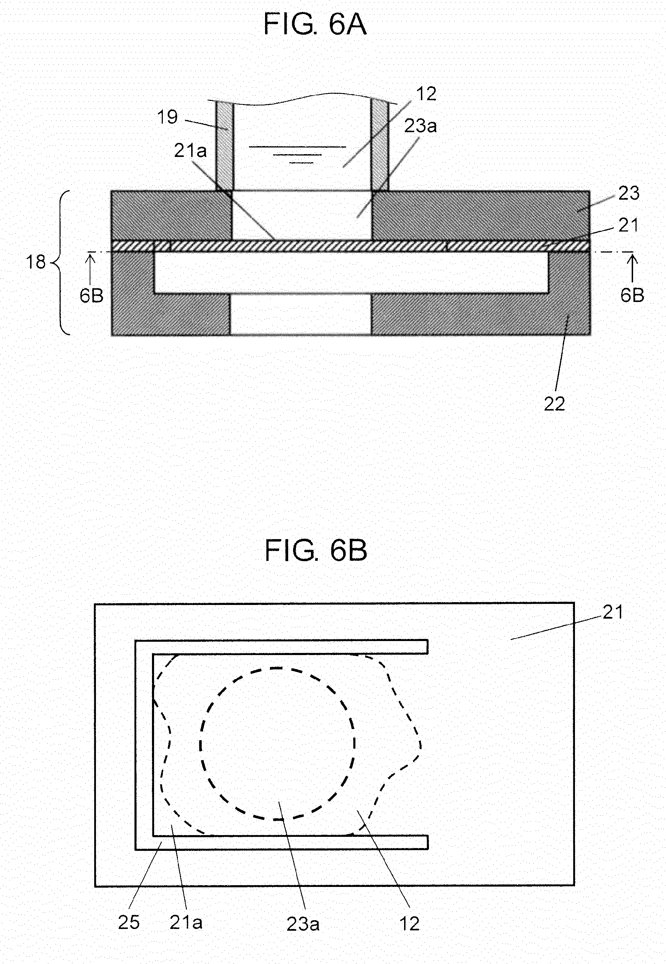

FIG. 6A is a sectional view of a state where the valve-movable portion of the check valve of the cooling apparatus of the first embodiment of the present invention closes the valve hole, and FIG. 6B is a sectional view taken along line 6B-6B in FIG. 6A. As shown in FIG. 6A, when a force for bringing up valve-movable portion 21a by pressure in heat receiving space 13 shown in FIG. 2 is greater than a force for pressing down valve-movable portion 21a by the head pressure of working fluid 12 which returns onto valve-movable portion 21a and by pressure in return path 7, valve-movable portion 21a closes valve hole 23a. Hence, it is possible to avoid a case where working fluid 12 in heat receiving space 13 shown in FIG. 2 reversely flows and returns toward return path 7, and working fluid 12 is reliably discharged from discharge port 16 to heat radiating path 6.

As shown in FIG. 6B, working fluid 12 exists also in a gap between valve-movable portion 21a and flat abutment surface 24. Hence, air tightness when check valve 18 shown in FIG. 2 is closed is enhanced. As a result, a cooling effect in heat receiving portion 4 becomes extremely high as compared with a conventional natural circulation type cooling apparatus. When chamfered portion 30 shown in FIG. 5A is provided, working fluid 12 smoothly spreads over valve plate 21. As a result, air tightness when check valve 18 is closed is further enhanced.

### SECOND EXEMPLARY EMBODIMENT

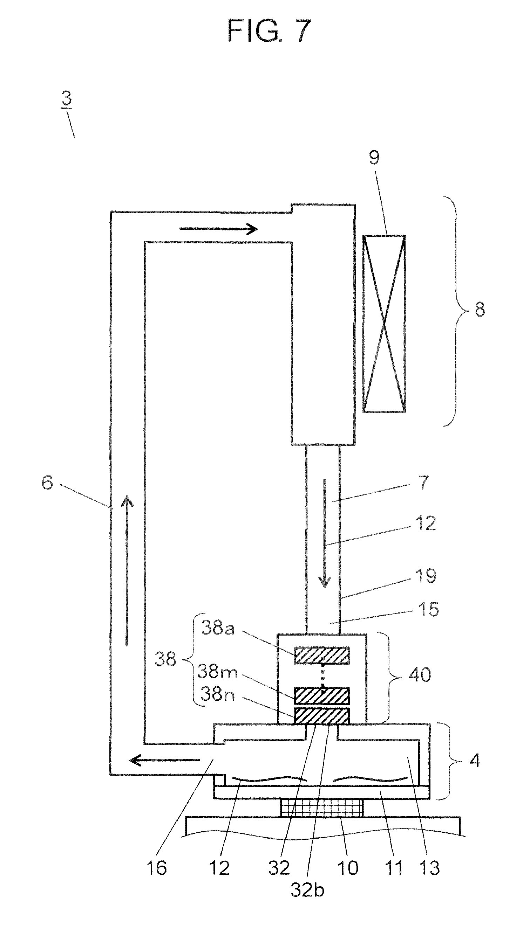

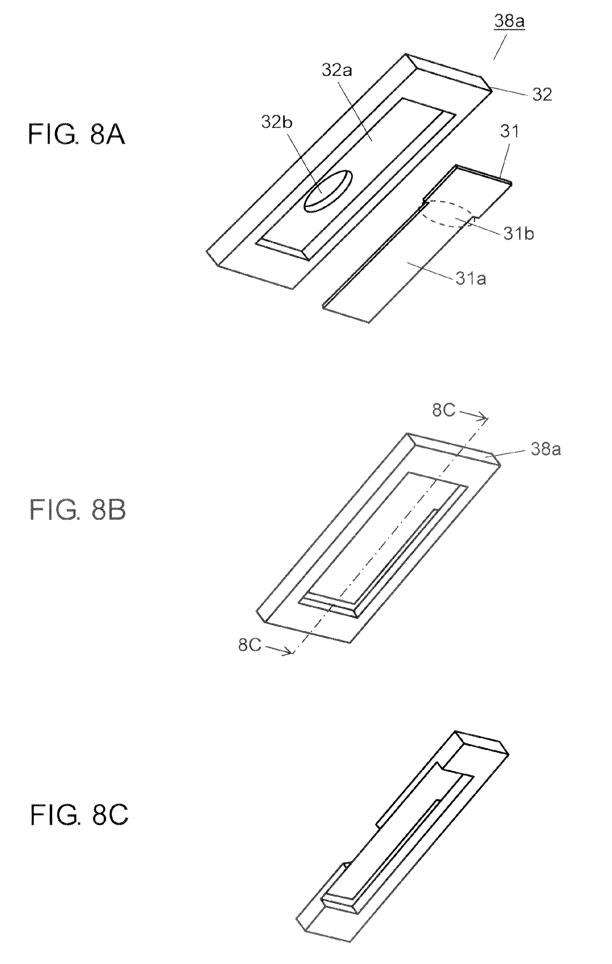

In a second embodiment of the present invention, the same reference marks are allocated to the same constituent elements as those of the first embodiment, and detailed description thereof will be omitted. FIG. 7 is a schematic diagram of a cooling apparatus of the second embodiment of the present invention, FIG. 8A is an exploded perspective view of a check valve of the cooling apparatus, FIG. 8B is a perspective view of an assembled state of the check valve of the cooling apparatus, and FIG. 8C is a sectional view taken along line 8C-8C in FIG. 8B.

In inflow pipe 19 immediately before check valve 38 in return path 7 shown in FIG. 7, working fluid 12 before it drops into heat receiving space 13 is collected as liquid. Normally, check valve 38 opens for several seconds or shorter, and working fluid 12 is supplied into heat receiving space 13.

Here, the question is durability of valve plate 31 shown in FIG. 8A. That is, pressure in heat receiving space 13 is increased by evaporation of working fluid 12 in heat receiving space 13 shown in FIG. 7, and check valve 38 is pushed up and closed. When working fluid 12 in heat receiving space 13 is reduced by evaporation, pressure in heat receiving space 13 is also reduced. As a result, check valve 38 is pushed down by the head pressure of working fluid 12 collected above check valve 38, and check valve 38 opens. By repeating the opening and closing operations of check valve 38, base 31b of valve-movable portion 31a of valve plate 31 shown in FIG. 8A is damaged in some cases. Even if valve plate 31 is made of copper or the like described above while taking durability into consideration, there is a possibility that a crack, a pinhole and the like are generated due to erosion caused by cavitation in heat receiving space 13.

When valve plate 31 is damaged as described above, a valve function of check valve 38 shown in FIG. 7 disappears, and working fluid 12 is always supplied into heat receiving space 13 or working fluid 12 from heat receiving space 13 reversely flows. As a result, a stable circulation function of working fluid 12 is lost, and the heat transfer efficiency of heat receiving plate 11 is extremely deteriorated. Hence, in the second embodiment of the present invention, there is provided check valve-mounting portion 40 provided with a plurality of check valves 38a to 38n. Check valve-mounting portion 40 is attached to return path 7 at one end next to heat receiving portion 4. A reason why the plurality of check valves are provided will be described later.

As shown in FIGS. 8A to 8C, a configuration of check valve 38a is vertically reversed as compared with that of the first embodiment because it is provided with check valves 38a to 38n, and valve plate 31 falls within recess 32a of case 32. As shown in FIG. 7, a position of the lowermost one of check valves 38a to 38n, i.e., a position of case hole 32b having the same diameter as an inner diameter of inflow pipe 19 provided in case 32 of check valve 38n which is closest to heat receiving portion 4 and a position of inflow port 15 of heat receiving portion 4 are made to match with each other. According to this configuration, like other check valves 38a to 38m, valve-movable portion 31a of valve plate 31 shown in FIG. 8A moves only in recess 32a of case 32.

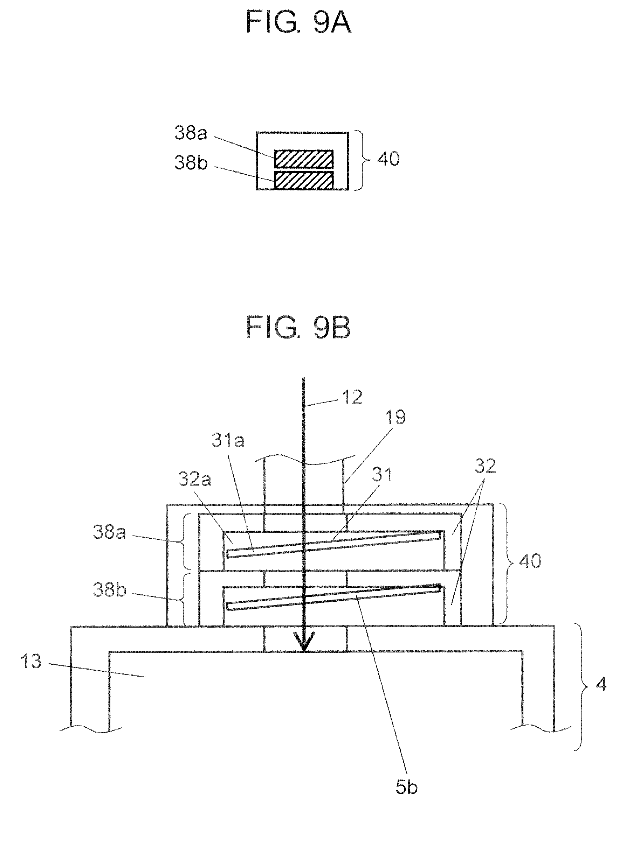

FIG. 9A is a schematic diagram of a configuration of the check valve-mounting portion of the cooling apparatus of the second embodiment of the present invention, and FIG. 9B is an enlarged diagram of the configuration of the check valve-mounting portion of the cooling apparatus. Using FIGS. 9A and 9B, operation when two check valves 38a and 38b are provided in check valve-mounting portion 40 will be described together with a reason why the plurality of check valves are provided. Here, in normal operation, only check valve 38b which is closer to heat receiving portion 4 functions.

As shown in FIGS. 9A and 9B, working fluid 12 is supplied from inflow pipe 19 to heat receiving portion 4 through check valves 38a and 38b, and liquid working fluid 12 is evaporated. As a result, pressure in heat receiving space 13 increases, lower check valve 38b is pushed up and closed. However, valve-movable portion 31a of valve plate 31 of upper check valve 38a floats in recess 32a of case 32 which is filled with working fluid 12.

Next, when an evaporation amount of working fluid 12 in heat receiving space 13 is reduced and pressure in heat receiving space 13 is reduced, check valve 38b is pushed down by the head pressure of working fluid 12 collected above check valve 38b. That is, check valve 38b opens and working fluid 12 is supplied into heat receiving space 13.

As described above, in the normal operation when two check valves 38a and 38b are provided in check valve-mounting portion 40, check valve 38a does not have a function as the check valve as compared with a case where one check valve 38b is provided. That is, check valve 38a almost always opens. Hence, by repetition of the opening and closing operations of check valve 38a, base 31b of valve-movable portion 31a of valve plate 31 shown in FIG. 8A is not damaged, and there is no influence of erosion caused by cavitation in heat receiving space 13. Check valve 38a functions as a check valve only when check valve 38b is deteriorated due to long-term use and check valve 38b cannot function as the check valve.

Thus, when check valve 38b is damaged, check valve 38a carries out the same operation as that of check valve 38b as described above, and maintenance period such as exchange of check valve 38 shown in FIG. 7 can be delayed. That is, time between periodical inspection periods becomes long.

In the first embodiment of the present invention, an example in which cooling apparatus 3 is applied to electric vehicle 1 has been described.

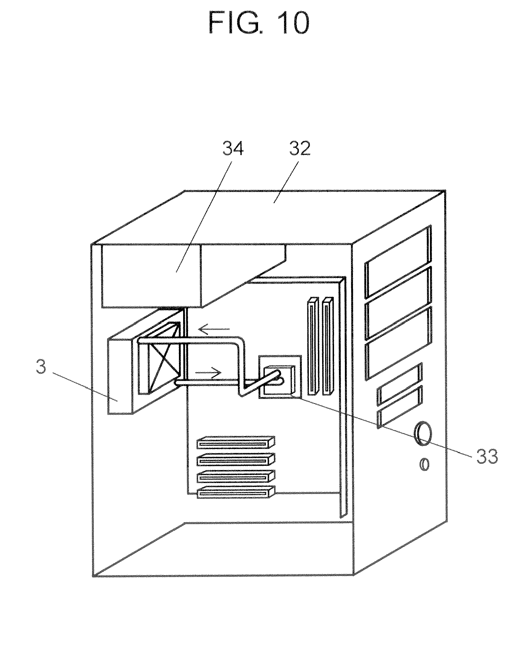

FIG. 10 is a schematic perspective view of the electronic apparatus provided with the cooling apparatus of the second embodiment of the present invention. FIG. 10 shows a case where the electronic apparatus is a personal computer. Cooling apparatus 3, heat source socket 33 which is the heat source, and power source unit 34 are provided in personal computer casing 32, and heat source socket 33 is cooled by cooling apparatus 3.

### INDUSTRIAL APPLICABILITY

The cooling apparatus of the present invention is effective for cooling a power semiconductor used for a power converter as a drive apparatus of an electric vehicle, and for cooling a CPU (Central Processing Unit) and the like having a high amount of the heat generation.

### REFERENCE MARKS IN THE DRAWINGS

- 1: electric vehicle
- 2: inverter circuit
- 3: cooling apparatus
- 4: heat receiving portion
- 5: heat radiating portion
- 6: heat radiating path
- 7: return path
- 8: heat radiating body
- 9: blower
- 10: semiconductor switching element (heat source)
- 10a: heat
- 11: heat receiving plate
- 12: working fluid
- 13: heat receiving space
- 14: heat receiving plate cover
- 15: inflow port
- 16: discharge port
- 17: introduction pipe
- 18, 38, 38a, 38b, 38m, 38n: check valve
- 19: inflow pipe
- 21, 31: valve plate
- 21a,: 31a valve-movable portion
- 21b: free end
- 21c: fixed end
- 22, 32: case
- 22a, 32b: case hole
- 22b, 32a: recess
- 23: valve seat
- 23a: valve hole
- 23b: valve hole-forming surface
- 23c: valve hole valve plate contact portion
- 24: flat abutment surface
- 25: cut-groove
- 26: region
- 27: metal plate
- 28: rolling direction
- 29: valve-movable portion direction
- 30: chamfered portion
- 31b: base
- 32: personal computer casing
- 33: heat source socket
- 34: power source unit
- 40: check valve-mounting portion

## Claims

1. A cooling apparatus comprising:
a heat receiving portion including a heat receiving plate which transfers heat from a heat source to a working fluid;
a heat radiating portion which discharges the heat of the working fluid; and
a heat radiating path and a return path, each connecting between the heat receiving portion and the heat radiating portion,
wherein the cooling apparatus dissipates the heat of the heat source by circulating the working fluid through the heat receiving portion, the heat radiating path, the heat radiating portion, the return path and back to the heat receiving portion, and
the cooling apparatus further comprises a check valve in the return path at a location near the heat receiving portion or in the heat receiving portion, for controlling a flow of the working fluid,
the check valve including:
a valve seat including a valve hole;
a case including a recess; and
a valve plate which is sandwiched between the valve seat and the case, which opens and closes the valve hole, and which includes a valve-movable portion that moves in the recess.

2. The cooling apparatus according to claim 1, wherein the check valve is opened by a head pressure of the working fluid collected above the check valve.

3. The cooling apparatus according to claim 1, wherein the valve plate is disposed horizontally.

4. The cooling apparatus according to claim 1, further comprising a check valve-mounting portion attached to the return path at one end next to the heat receiving portion, the check valve-mounting portion including a plurality of the check valves.

5. The cooling apparatus according to claim 1, wherein the valve seat includes a flat abutment surface which is in close contact with the valve plate.

6. The cooling apparatus according to claim 1, wherein the valve-movable portion is a region surrounded by a U-shaped cut-groove provided in the valve plate, and the valve-movable portion includes a free end whose displacement from the valve plate is largest, and a fixed end whose displacement from the valve plate is zero.

7. The cooling apparatus according to claim 6, wherein the valve plate is a rolled metal plate, of which a rolling direction is the same as a valve-movable portion direction from the fixed end toward the free end.

8. The cooling apparatus according to claim 7, wherein the valve plate is the metal plate which is cut in a direction from one side facing the valve seat to another side facing the case.

9. The cooling apparatus according to claim 1, wherein a valve hole-forming surface which forms the valve hole is in contact with the valve plate at a valve hole valve plate contact portion, and the valve hole valve plate contact portion is provided with a chamfered portion.

10. An electronic apparatus comprising:
the cooling apparatus according to claim 1; and
a cooling target which is cooled by the cooling apparatus.

11. An electric vehicle comprising:
the cooling apparatus according to claim 1; and
the heat source which is cooled by the cooling apparatus.
